Europäisches Patentamt

European Patent Office

Office européen des brevets

(19)

(11) EP 0 780 996 A2

(12) EUROPÄISCHE PATENTANMELDUNG

(43) Veröffentlichungstag:
25.06.1997 Patentblatt 1997/26

(51) Int Cl.6: H04B 7/155

(21) Anmeldenummer: 96890192.6

(22) Anmeldetag: 16.12.1996

(84) Benannte Vertragsstaaten:
AT BE CH DE FR LI NL SE

(30) Priorität: 21.12.1995 AT 2086/95

(71) Anmelder: KAPSCH AKTIENGESELLSCHAFT
A-1121 Wien (AT)

(72) Erfinder:
• Trollmann, Wilfried, Dipl.-Ing.
1100 Wien (AT) (AU)

• Fischer, Peter Hans, Dipl.-Ing.
1230 Wien (AT) (AU)

(74) Vertreter: Weiser, Andreas
Patentanwälte Schütz u.Partner,
Fleischmanngasse 9
1040 Wien (AT)

(54) **Zwischenverstärker für eine Relaisstation**

(57) Zwischenverstärker für eine Relaisstation zum universellen Einsatz mit aus Trägerbursts (10) zusammengesetzten, periodischen TDMA-Signalen (11) und gegebenenfalls Dauerträgersignalen (12) in Funktelephonnetzen, insbesondere zur Übertragung von Sendesignalen zwischen Mobilstationen in abgeschirmten Fahrzeugen und Basisstationen im Freifeld, mit einem regelbaren, insbesondere breitbandigen Hochfrequenzverstärker (4) im Signalweg (1), dessen Verstärkung über einen vom Signalweg (1) abzweigenden Regelweg (6) gesteuert ist, wobei der Regelweg (6) in Aufeinanderfolge eine Leistungsmeßeinrichtung (7) zur Bestimmung der Signalleistung des Signalweges (1), einen Mittelwertbildner (8) zur zeitlichen Mittelung der Signalleistung und Zwischenspeicherung des Mittelwertes über die Dauer ($T_B$, $t_m$) eines Trägerbursts (10) oder eines ganzzahligen Teiles davon, sowie ein Zeitverzögerungsglied (9) für das Regelsignal umfaßt, dessen Verzögerungszeit ($\Delta T$) der Periodizität ($T_P$) des TDMA-Signales (11) oder einem ganzzahligen Vielfachen davon, vermindert um die genannte Dauer ($T_B$, $t_m$), entspricht.

Fig. 1

**Beschreibung**

Die vorliegende Erfindung betrifft einen Zwischenverstärker für eine Relaisstation zum universellen Einsatz mit aus Trägerbursts zusammengesetzten, periodischen TDMA-Signalen und gegebenenfalls Dauerträgersignalen in Funktelephonnetzen, insbesondere zur Übertragung von Sendesignalen zwischen Mobilstationen in abgeschirmten Fahrzeugen und Basisstationen im Freifeld, mit einem regelbaren, insbesondere breitbandigen Hochfrequenzverstärker im Signalweg, dessen Verstärkung über einen vom Signalweg abzweigenden Regelweg gesteuert ist.

Zum Betreiben von Mobilstationen in abgeschirmten Räumen, wie Tunnels, unterirdischen Bahnhöfen, abgeschirmten Fahrzeugen usw. werden Relaisstationen ("Repeater") eingesetzt, welche die im Freifeld ausgesendeten Frequenzkanäle empfangen, in einem Zwischenverstärker verstärken und in den abgeschirmten Raum wieder ausstrahlen und umgekehrt. Zum einen werden Systeme mit mehreren schmalbandigen Zwischenverstärkern verwendet, welche eine bestimmte Zahl von vorgegebenen Frequenzkanälen weiterleiten, und zum anderen gibt es Systeme mit Breitband-Zwischenverstärkern, die alle vorhandenen Kanäle übertragen. Systeme der ersten Art eignen sich insbesondere für stationäre Relaisstationen, bei welchen die Frequenzen der umliegenden Basisstationen bekannt sind, so daß nur deren Kanäle in den abgeschirmten Raum eingespeist bzw. die zugeordneten Aufwärtsverbindungskanäle vom abgeschirmten Raum in das Freifeld übertragen werden müssen. Bei einer Variante der ersten Systemart werden die Schmalbandverstärker an Hand einer Kanalabtastung auf die erforderlichen Kanäle eingestellt, was jedoch entsprechend aufwendig ist.

Die Versorgung eines "mobilen" abgeschirmten Raumes, z.B. eines Eisenbahnwaggons mit metallisierten Scheiben, läßt sich mit vertretbarem Aufwand nur mit Hilfe von Systemen der zweiten Art realisieren, weil das Kanalumfeld des mobilen Raumes nicht bekannt ist und sich ständig ändert.

Dabei ergibt sich die Problemstellung, daß bei bestimmten Funktelephonnetz-Systemen, z.B. dem GSM-Netz (global system for mobile communication), mehrere Gesprächsverbindungen auf einem Kanal zeitlich aufeinanderfolgend in zugeordneten Zeitschlitzen übertragen werden, die jeweils einen Trägerburst enthalten. Das sich ergebende Signal wird als TDMA-Signal (time division multiple access signal) bezeichnet. Zumal die Sendeleistung verschiedener Mobilstationen in der Regel unterschiedlich ist und überdies nicht immer alle Zeitschlitze besetzt sind, hat das TDMA-Signal im zeitlichen Verlauf eine stark schwankende Leistung. Um eine Übersteuerung des Zwischenverstärkers in der Relaisstation zu vermeiden, müßte der Zwischenverstärker entweder mit einem entsprechend großen Dynamikbereich, d.h. extrem hoher Ausgangsleistung ausgelegt werden, was in der Praxis nicht vertretbar ist, oder es wird eine automatische Verstärkungsregelung für den Zwischenverstärker vorgesehen, welche die Signalleistung des Signalweges auswertet (z.B. US 5 095 528, EP 114 066, GB 2 257 874).

Die Verstärkungsregelung muß eine ausreichend große Bandbreite haben, um den Leistungsschwankungen des TDMA-Signales rasch folgen zu können, so daß eine Verformung der Flanken der Trägerbursts weitgehend ausgeschlossen ist. Eine große Bandbreite des Regelweges (z.B. > 200 kHz) hat jedoch den Nebeneffekt, daß sich niederfrequente Mischungsprodukte gleichzeitig sendender Mobilstationen direkt auf die Verstärkungsregelung auswirken. Wenn beispielsweise zwei Mobilstationen gleichzeitig senden, deren Trägerfrequenzen einen Abstand von 100 kHz haben, wird das Zwischenverstärkersignal über den Regelweg mit einer 100 kHz-Schwebung moduliert.

Wenn in dem abgeschirmten Raum ausschließlich Mobilstationen des TDMA-Systems betrieben werden, ist es auf Grund der zeitlichen Verteilung der Trägerbursts der einzelnen Mobilstationen ausgesprochen selten, daß zwei Mobilstationen zum gleichen Zeitpunkt mit knapp nebeneinanderliegenden Sendefrequenzen senden. Werden in dem Raum jedoch zusätzlich Mobilstationen mit Dauerträgern betrieben, wie es z.B. bei ETACS (extended total access communication system) der Fall ist ("D-Netz"), ist die Wahrscheinlichkeit für das Auftreten des genannten Effektes wesentlich größer.

Die Erfindung setzt sich zum Ziel, einen Zwischenverstärker für eine Relaisstation zu schaffen, der mit wirtschaftlich vertretbarem Aufwand eine weitgehend störungsfreie Übertragung sowohl von TDMA-Signalen als auch allfälligen Dauerträgersignalen in Funktelephonnetzen gestattet. Dieses Ziel wird mit Hilfe eines Zwischenverstärkers der einleitend genannten Art erreicht, der sich gemäß der Erfindung dadurch auszeichnet, daß der Regelweg in Aufeinanderfolge eine Leistungsmeßeinrichtung zur Bestimmung der Signalleistung des Signalweges, einen Mittelwertbildner zur zeitlichen Mittelung der Signalleistung und Zwischenspeicherung des Mittelwertes über die Dauer eines Trägerbursts oder eines ganzzahligen Teiles des letzteren, sowie ein Zeitverzögerungsglied für das Regelsignal umfaßt, dessen Verzögerungszeit der Periodizität des TDMA-Signales oder einem ganzzahligen Vielfachen davon, vermindert um die genannte Dauer, enspricht.

Auf diese Weise wird Nutzen aus der gegebenen Periodizität des TDMA-Signales gezogen. Die mit Hilfe der Mittelwertbildung von störenden Mischungsprodukten befreite Leistungsmessung eines Trägerbursts wird als Voraussagewert für die Einstellung des darauffolgenden Trägerbursts derselben Mobilstation verwendet. Bei der Einstellung des nachfolgenden Trägerbursts kann die Regelung augenblicklich, d.h. ideal schnell vorgenommen werden. Die Regelung erfolgt "burstweise", wenn der Mittelwert jeweils über einen gesamten Trägerburst gebildet und auf den nach der Verzögerungszeit folgenden Trägerburst angewendet wird, oder auch in Inkrementen von ganzzahligen Teilen eines Trägerbursts.

Eine bevorzugte Weiterbildung der Erfindung besteht darin, daß das Ausgangssignal der Leistungsmeßeinrichtung einem Flankendetektor zugeführt ist, welcher den Beginn der Mittelung des Mittelwertbildners auf eine ansteigende Flanke des Ausgangssignales der Leistungsmeßeinrichtung synchronisiert. Auf diese Weise kann die Genauigkeit der Regelung weiter erhöht werden.

Besonders vorteilhaft ist es, wenn der Mittelwertbildner zeitdiskrete Abtastwerte summiert und der Flankendetektor nach Erkennung einer ansteigenden Signalflanke den vorangegangenen Abtastwert für den Mittelwertbildner durch den aktuellen Abtastwert ersetzt und den Beginn der Mittelwertbildung auf den vorangegangenen Abtastwert synchronisiert. Dadurch wird ein gegenüber einem vorhergehenden Trägerburst ansteigender Trägerburst von seinem Flankenbeginn an mit einer höheren Leistung bewertet, so daß die Verstärkungsregelung des Zwischenverstärkers diesen vorsorglich (d.h. bereits beim ersten Einsetzen des nach der Verzögerungszeit folgenden Trägerbursts) in seiner Verstärkung anpaßt, um ein Übersteuern unter allen Umständen zu verhindern.

Eine weitere bevorzugte Ausführungsform der Erfindung besteht darin, daß das Ausgangssignal der Leistungsmeßeinrichtung einer Logiksteuereinheit zugeführt ist, welche die einer bestimmten Mobilstation zugeordneten Trägerbursts fortlaufend überwacht und ab dem Ausbleiben eines Trägerburstes das dem letzten zugeordneten Trägerburst entsprechende Regelsignal für eine vorgegebene Anzahl von folgenden zugeordneten Trägerbursts an den Hochfrequenzverstärker anlegt. Dies trägt der Tatsache Rechnung, daß neuere TDMA-Standards in Sprachpausen auf Trägerbursts verzichten und lediglich in größeren Abständen das Aussenden eines mit spezieller Standby-Information versehenen Trägerbursts erfordern.

Besonders günstig ist es, wenn gemäß einem weiteren Merkmal der Erfindung das Ausgangssignal der Leistungsmeßeinrichtung einer Logiksteuereinheit zugeführt ist, welche die Statistik, z.B. Periodizität und Burstanzahl pro Periode, des TDMA-Signales aus dem Leistungsmeßsignal ermittelt und die Dauer der Mittelung und Zwischenspeicherung und/oder die Verzögerungszeit des Zeitverzögerungsgliedes daran anpaßt. Dadurch kann der Zwischenverstärker mit beliebigen Funktelephonnetzen unterschiedlicher TDMA-Signalstandards zusammenarbeiten.

Die Erfindung wird nachstehend an Hand von in den Zeichnungen dargestellten Ausführungsbeispielen näher erläutert. In den Zeichnungen zeigt

Fig. 1 das Blockschaltbild einer ersten Ausführungsform des Zwischenverstärkers gemäß der Erfindung,
Fig. 2 das Blockschaltbild einer zweiten Ausführungsform,
Fig. 3 ein Diagramm des zeitlichen Verlaufes der Leistung eines beispielhaften TDMA-Signales und
Fig. 4 einen der Trägerbursts des TDMA-Signales von Fig. 3 in vergrößerter Darstellung.

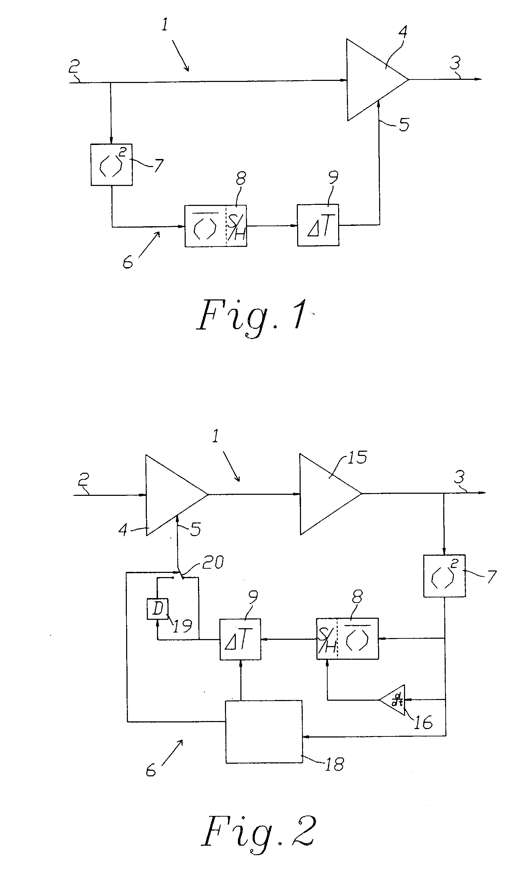

In Fig. 1 ist eine einfache Ausführungsform eines Zwischenverstärkers gemäß der Erfindung dargestellt. Der Zwischenverstärker weist einen Signalweg 1 zwischen einem Eingang 2 und einem Ausgang 3 auf, in welchem Signalweg ein Hochfrequenzverstärker 4 liegt. Die Verstärkung des Hochfrequenzverstärkers 4 wird über einen Regeleingang 5 durch ein Regelsignal geregelt, das von einem Regelweg 6 erhalten wird. Der Regelweg 6 ist mit seinem Eingang an den Signalweg 1 angeschaltet, u.zw. bei dem in Fig. 1 gezeigten Beispiel an einem Punkt vor dem Hochfrequenzverstärker 4. Im Regelweg 6 liegen hintereinander eine Leistungsmeßeinrichtung 7, ein spezifisch ausgebildeter Mittelwertbildner 8 und ein Verzögerungsglied 9.

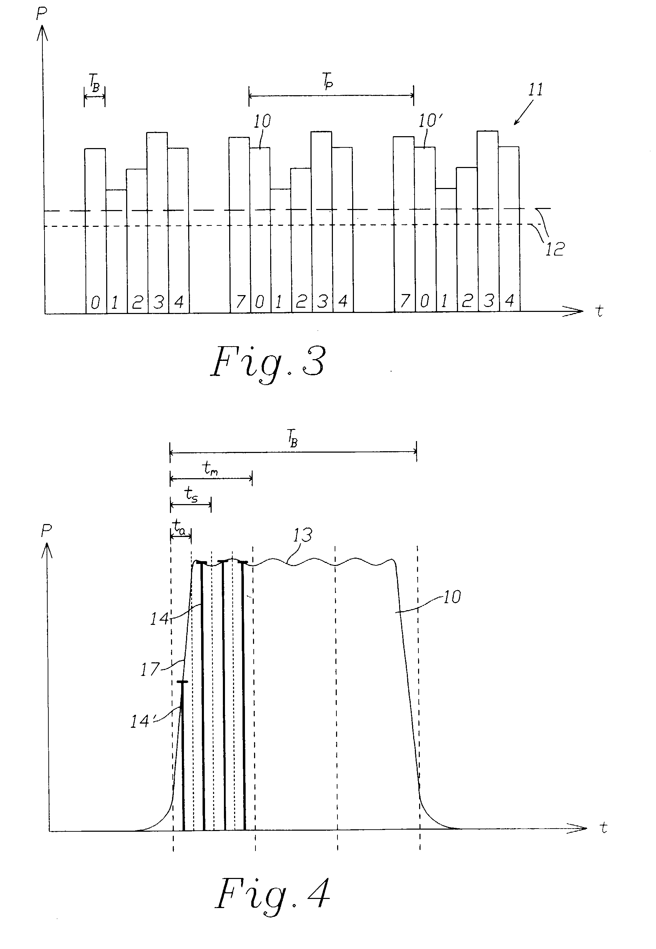

Zur Beschreibung der Funktionsweise des Regelweges 6 wird auf Fig. 3 Bezug genommen, welche den zeitlichen Verlauf der Sendeleistung P von sechs Mobilstationen eines TDMA-Systems zeigt, die zyklisch auf den Zeitschlitzen 0, 1, 2, 3, 4 und 7 eines TDMA-Systems mit acht Zeitschlitzen senden (ausgezogene Kurve). Jede einzelne Mobilstation sendet periodisch einen Trägerburst 10 der Dauer $T_B$, wobei die Periodizität $T_P$ beträgt. Die Trägerbursts 10 bilden gemeinsam das TDMA-Signal 11. Beispielhafte Werte für ein reales TDMA-Signal sind $T_p = 60/13$ ms ($\approx 4{,}6$ ms) und $T_B = 7500/13$ µs ($\approx 577$ µs).

Zusätzlich sind in Fig. 3 die zeitlichen Verläufe der Senderleistung P zweier weiterer Mobilstationen dargestellt (strichlierte Kurven), welche mit Dauerträgern 12 senden. Das (nicht eingezeichnete) Überlagerungssignal der Trägerbursts 10 und der Dauerträger 12 wird von der Leistungsmeßeinrichtung 7 gemessen und tritt an deren Ausgang auf. In der Praxis können auch mehrere, aus Trägerbursts 10 zusammengesetzte TDMA-Signale 11 auf verschiedenen Frequenzkanälen zusammen mit Dauerträgersignalen 12 unterschiedlicher Frequenzkanäle überlagert sein.

Ziel der Regelung des Hochfrequenzverstärkers 4 ist es, den Dynamikbereich auf dem Signalweg zu verringern, um eine optimale Aussteuerung des Hochfrequenzverstärkers 4 im zeitlichen Verlauf zu erreichen, d.h. bei Trägerbursts hoher Leistung wird die Verstärkung des Hochfrequenzverstärkers 4 verringert und umgekehrt.

Um eine schnelle Reaktion auf die Stufensprünge des Lei-stungssignales von Fig. 3 zu gewährleisten, müßte der Regelweg 6 entsprechende Bandbreite haben, z.B. über 200 kHz, andernfalls die Flanken der Trägerbursts verschliffen oder übersteuert werden könnten. Auf Grund des engen Kanalrasters sowohl von TDMA- als auch Dauerträger-Funktelephonnetzen (z.B. 100 kHz, manchmal bis zu 25 kHz) treten im Leistungsmeßsignal niederfrequente (100 kHz bzw. 25 kHz) Mischungsprodukte auf, welche von einem breitbandigen Regelweg 6 durchgelassen und das Verstärkersignal modulieren würden. Die Auswirkung einer derartigen Störung auf einen beispielhaften Trägerburst 10 ist in Fig. 4 veranschaulicht. Der Trägerburst 10 ist mit einem Mischungsprodukt 13 moduliert, das eine Periodendauer $t_s$ hat. (In der Praxis ist die Amplitude des Mischungsproduktes 13 im Verhältnis zu der Leistung des Trägerbursts 10 beträchtlich größer als dargestellt).

Um den Einfluß des Mischungsproduktes 13 auf die Verstärkungsregelung auszuschließen, führt der Mittelwertbildner 8 eine Mittelwertbildung über eine Dauer $t_m$ durch. Bei dem in Fig. 4 gezeigten Beispiel erfolgt dies auf digitalem Wege, wobei das Intervall $t_m$ in vier Abstastintervalle $t_a$ unterteilt und in jedem Abtastintervall 4 ein Abtastwert 14 genommen wird. Der Mittelwertbildner 8 summiert die Abtastwerte 14 im Intervall $t_m$, teilt die Summe durch die Anzahl der Abtastwerte und liefert am Ende Intervalles $t_m$ den Mittelwert für dieses Intervall. Anschließend berechnet der Mittelwertbildner 8 den Mittelwert für das folgende Intervall $t_m$. Während der Dauer $t_m$ der Mittelwertberechnung bleibt der Mittelwert des vorherigen Intervalles zwischengespeichert und steht am Ausgang des Mittelwertbildners 8 zur Verfügung.

Anstelle der Mittelwertbildung auf digitalem Wege könnte dieselbe Funktion auch analog realisiert werden. Beispielsweise könnte die Mittelwertbildung mit Hilfe eines Tiefpaßfilters durchgeführt werden, an das ein Abtast- und Halteglied anschließt, welches den für das Intervall $t_m$ erhaltenen Mittelwert über die Dauer des nächsten Mittelungsintervalles $t_m$ festhält.

Das Ausgangssignal des Mittelwertbildners 8 wird anschließend im Verzögerungsglied 9 um eine Zeit $\Delta T$ verzögert, welche gleich der Differenz aus der Periodizität $T_P$ des TDMA-Signales und der Dauer $t_m$ der Mittelung ist, d.h.:

$$\Delta T = T_P - t_m$$

Somit steht als Regelsignal für den Hochfrequenzverstärker von Beginn eines Trägerbursts 10' an ein (geschätztes) Regelsignal zur Verfügung, welches aus der Leistung des vorhergehenden, derselben Mobilstation zugeordneten Trägerbursts 10 ermittelt worden ist (Fig. 3).

Die Regelung läßt sich in gleicher Weise bei TDMA-Standards verwenden, bei welchen ein Zeitschlitz jeweils abwechselnd von zwei verschiedenen Mobilstationen benützt wird (half rate channel), wenn die Verzögerungszeit $\Delta T$ auf $2T_p - t_m$ eingestellt wird. Allgemein gilt:

$$\Delta T = nT_p - t_m \qquad (n = 1..N)$$

Für eine ordnungsgemäße Funktion der Regelung ist es erforderlich, daß die Mittelungsdauer $t_m$ einem ganzzahligen Teil der Dauer $T_p$ eines Trägerburstes 10 entspricht, d.h.:

$$t_m = T_P/n \qquad (n = 1..N)$$

Es ist ohne weiteres möglich, die Mittelungsdauer $t_m$ gleich der Trägerburstdauer $T_B$ zu setzen (n = 1), in welchem Fall die Regelung in Zeitinkrementen der Trägerburstdauer erfolgt, d.h. "burstweise".

Zur korrekten Mittelwertbildung ist es weiterhin erforderlich, daß die Dauer eines Abtastintervalles $t_a$ ein ganzzahliger Teil der Mittelungsdauer $t_m$ ist, d.h.:

$$t_a = t_m/n \qquad (n = 1..N)$$

Ferner ist:

$$t_a < t_s/2$$

Dadurch stehen zumindest zwei Abtastwerte jeder Schwingung 13 zur Mittelung zur Verfügung.

In Fig. 2 ist eine alternative Ausführungsform des erfindungsgemäßen Zwischenverstärkers dargestellt, wobei der Regelweg 6 hier an den Ausgang 3 des Signalweges 1 angeschaltet ist. Dadurch wird eine Regelschleife gebildet, welche die Komponenten des Hochfrequenzverstärkers 4 sowie allfällig nachgeschaltete Endverstärker 15 einbezieht, so daß deren Toleranzen, Temperaturdriften usw. kompensiert werden können.

Bei der Ausführungsform von Fig. 2 ist an den Ausgang der Leistungsmeßeinrichtung 7 zusätzlich ein Flankendetektor 16 angeschlossen. Der Flankendetektor 16 erkennt die ansteigende Flanke 17 (Fig. 4) eines Trägerbursts 10 und synchronisiert den Beginn des Mittelungsintervalles $t_m$ des Mittelwertbildners 8 auf diesen Zeitpunkt. Es ist nicht erforderlich (und bei zwei aufeinanderfolgenden Trägerbursts gleicher Leistung tatsächlich auch nicht möglich), daß der Flankendetektor 16 die Flanke jedes Trägerbursts 10 erkennt, sondern es genügt, wenn dies von Zeit zu Zeit geschieht, um eine Nachsynchronisierung des Mittelwertbildners 8 durchzuführen.

Mit Hilfe des Flankendetektors 16 kann zusätzlich eine Korrektur der Mittelwertbildung des Mittelwertbildners 8 durchgeführt werden. Bei Erkennung einer ansteigenden Signalflanke 17 ersetzt der Flankendetektor 16 den Abtastwert 14' eines vorangegangenen Abtastintervalles $t_a$ durch den Abtastwert 14 des aktuellen Abtastintervalles $t_a$ und synchronisiert den Beginn des Mittelungsintervalles $t_m$ auf den Abtastwert 14'. Dadurch wird ein Übersteuern des Hochfrequenzverstärkers 4 am Beginn des Trägerbursts 10' vermieden.

Die Ausführungsform von Fig. 2 enthält ferner eine Einrichtung, welche der Eigenschaft bestimmter Funktelephonnetzstandards Rechnung trägt, wonach Trägerbursts 10 in Sprachpausen unterdrückt und lediglich in größeren Abständen (bis zu 0,5 s) Trägerbursts mit Standby-Information gesendet werden ("DTX", discontinous transmit). Bei Ausbleiben eines Trägerburstes würde die Regelung mit der Verzögerung einer TDMA-Periode die Verstärkung auf maximal bzw. einen vorgewählten Ruhewert einstellen; ein späteres Wiedereinsetzen der Trägerbursts dieses Zeitschlitzes könnte zu einer Übersteuerung des Hochfrequenzverstärkers führen.

Um dies zu verhindern, ist an die Leistungsmeßeinrichtung 7 eine Logiksteuereinheit 18 angeschlossen, die im Falle eines Ausbleibens der Trägerbursts einer bestimmten Mobilstation das zuletzt ermittelte Regelsignal für eine vorgegebene, zumindest den DTX-Abstand übersteigende Zeitspanne auf die darauffolgenden Zeitschlitze dieser Mobilstation anwendet. Zu diesem Zweck ist ein Zwischenspeicher 19 für das Regelsignal vorgesehen, und die Logiksteuereinheit schaltet mit Hilfe eines Schalters 20 entsprechend zwischen dem Speicherinhalt und dem Regelsignal Um. Der Zwischenspeicher 19 und der Schalter 20 können alternativ auch an anderer Stelle als in dem Schaltbild von Fig. 2 gezeigt angeordnet werden, beispielsweise zwischen Mittelwertbildner 8 und Verzögerungsglied 9.

Die Logiksteuereinheit 18 kann zusätzlich so programmiert sein, daß sie an Hand einer statistischen Auswertung des Leistungsmeßsignales die Periodizität $T_P$, die Burstanzahl pro Periode, die Trägerburstdauer $T_B$ u.dgl. berechnet und danach die Dauer der Mittelung und Zwischenspeicherung $t_m$ bzw. die Verzögerungszeit $\Delta T$ einstellt.

Es versteht sich, daß die schaltungstechnische Realisierung des vorgestellten Zwischenverstärkers auf alle dem Fachmann bekannten Arten ausgeführt werden kann. Insbesondere kann zur Realisierung der Leistungsmeßeinrichtung 7, des Mittelwertbildners 8, des Verzögerungsgliedes 9, des Flankendetektors 16, der Logiksteuereinheit 18, des Speichers 19 und des Schalters 20 ein entsprechend programmierter digitaler Signalprozessor verwendet werden, auf dem die Funktionen dieser Komponenten in bekannter Weise als Programmelemente implementiert sind.

**Patentansprüche**

1. Zwischenverstärker für eine Relaisstation zum universellen Einsatz mit aus Trägerbursts zusammengesetzten, periodischen TDMA-Signalen und gegebenenfalls Dauerträgersignalen in Funktelephonnetzen, insbesondere zur Übertragung von Sendesignalen zwischen Mobilstationen in abgeschirmten Fahrzeugen und Basisstationen im Freifeld, mit einem regelbaren, insbesondere breitbandigen Hochfrequenzverstärker im Signalweg, dessen Verstärkung über einen vom Signalweg abzweigenden Regelweg gesteuert ist, dadurch gekennzeichnet, daß der Regelweg (6) in Aufeinanderfolge eine Leistungsmeßeinrichtung (7) zur Bestimmung der Signalleistung des Signalweges (1), einen Mittelwertbildner (8) zur zeitlichen Mittelung der Signalleistung und Zwischenspeicherung des Mittelwertes über die Dauer ($T_B$, $t_m$) eines Trägerbursts (10) oder eines ganzzahligen Teiles des letzteren, sowie ein Zeitverzögerungsglied (9) für das Regelsignal umfaßt, dessen Verzögerungszeit ($\Delta T$) der Periodizität ($T_P$) des TDMA-Signales (11) oder einem ganzzahligen Vielfachen davon, vermindert um die genannte Dauer ($T_B$, $t_m$), entspricht.

2. Zwischenverstärker nach Anspruch 1, dadurch gekennzeichnet, daß das Ausgangssignal der Leistungsmeßeinrichtung (7) einem Flankendetektor (16) zugeführt ist, welcher den Beginn der Mittelung des Mittelwertbildners (8) auf eine ansteigende Flanke (17) des Ausgangssignales der Leistungsmeßeinrichtung (7) synchronisiert.

3. Zwischenverstärker nach Anspruch 1 oder 2, dadurch gekennzeichnet, daß der Mittelwertbildner (8) zeitdiskrete Abtastwerte (14) summiert und der Flankendetektor (16) nach Er) kennung einer ansteigenden Signalflanke (17) den vorangegangenen Abtastwert (14') für den Mittelwertbildner (8) durch den aktuellen Abtastwert (14) ersetzt und den Beginn der Mittelwertbildung auf den vorangegangenen Abtastwert (14') synchronisiert.

4. Zwischenverstärker nach einem der Ansprüche 1 bis 3, dadurch gekennzeichnet, daß das Ausgangssignal der Leistungsmeßeinrichtung (7) einer Logiksteuereinheit (18) zugeführt ist, welche die einer bestimmten Mobilstation zugeordneten Trägerbursts (10) fortlaufend überwacht und ab dem Ausbleiben eines Trägerburstes das dem letzten zugeordneten Trägerburst (10) entsprechende Regelsignal für eine vorgegebene Anzahl von folgenden zugeordneten Trägerbursts (10) an den Hochfrequenzverstärker (4) anlegt.

5. Zwischenverstärker nach einem der Ansprüche 1 bis 4, dadurch gekennzeichnet, daß das Ausgangssignal der Leistungsmeßeinrichtung (7) einer Logiksteuereinheit (18) zugeführt ist, welche die Statistik, z.B. Periodizität ($T_P$) und Burstanzahl pro Periode, des TDMA-Signales (11) aus dem Leistungsmeßsignal ermittelt und die Dauer der Mittelung und Zwischenspeicherung ($T_B$, $t_m$) und/oder die Verzögerungszeit ($\Delta T$) des Zeitverzögerungsgliedes (9) daran anpaßt.

*Fig. 1*

*Fig. 2*

Fig.3

Fig.4